# EUROPEAN PATENT APPLICATION

(11) **EP 1 906 450 A1**
(43) Date of publication of application: **02.04.2008**
(21) Application number: 05765515.1
(22) Date of filing: 11.07.2005
(51) Int. Cl.: H01L 27/12, H01L 21/322

(54) **PROCESS FOR PRODUCING SIMOX SUBSTRATE, AND SIMOX SUBSTRATE PRODUCED BY SAID PROCESS**

(71) Applicant: SUMCO CORPORATION, Tokyo 105-8634 (JP)
(72) Inventor: ADACHI, Naoshi Sumitomo Mitsubishi Silicon Corp., Tokyo; 1058634 (JP); KOMATSU, Yukio Sumitomo Mitsubishi Silicon Corp., Tokyo; 1058634 (JP)
(74) Representative: Albrecht, Thomas
(86) International application number: PCT/JP2005/012734
(87) International publication number: WO 2007/007386

(57) **Abstract**

Heavy metal contamination in a device process can be efficiently trapped in a substrate.

The present invention comprises: a step of implanting oxygen ions into a wafer; a step of performing a first heat treatment to the wafer in a predetermined gas atmosphere at 1300 to 1390°C to form a buried oxide layer and also form an SOI layer on a wafer front surface, the wafer before the oxygen ion implantation having an oxygen concentration of 8x10¹⁷ to 1.8x10¹⁸ atoms/cm³ (old ASTM), the buried oxide layer being formed over the entire wafer surface, the present invention being **characterized by** including: a step of performing a second heat treatment to the wafer subjected to the first heat treatment in a predetermined gas atmosphere at 400 to 900°C for 1 to 96 hours to form oxide precipitate nuclei in a bulk layer below a defect aggregate layer formed immediately below the buried oxide layer; and a step of performing a third heat treatment to the wafer subjected to the second heat treatment in a predetermined gas atmosphere at 900 to 1250°C higher than the second heat treatment temperature for 1 to 96 hours to grow the formed oxide precipitate nuclei into oxide precipitates.

## Description

### TECHNICAL FIELD

The present invention relates to a method of manufacturing a SIMOX substrate based on a SIMOX (Separation by Implanted Oxygen) technology in SOI (Silicon-On-Insulator) substrates each having a structure where a single-crystal silicon layer (which will be referred to as an SOI layer hereinafter) is formed in a silicon single-crystal main body through a buried oxide layer, and a SIMOX substrate obtained by this method. More particularly, the present invention relates to a method of manufacturing a SIMOX substrate that can efficiently trap heavy metal contamination in a device process in the substrate, and a SIMOX substrate obtained by this method.

### BACKGROUND ART

An SOI substrate has very excellent characteristics, i.e., (1) a speed of a device operation can be increased since a parasitic capacitance between an element and a substrate can be reduced, (2) a radiation resistivity is excellent, (3) high integration is possible because dielectric isolation is easy, and (4) latch-up resisting characteristics can be improved. At the present day, a method of manufacturing the SOI substrate can be roughly classified into two. One method is a bonding method of forming the SOI substrate by bonding an active wafer formed into a thin film to a support wafer, and the other method is a SIMOX method of implanting oxygen ions from a wafer front surface to form a buried oxide layer in a region having a predetermined depth from the wafer front surface. In particular, the SIMOX method is expected to be an effective technique in the future since it has the small number of manufacturing steps.
A method of manufacturing a SIMOX substrate includes an oxygen ion implantation step of mirror-processing one main surface of a silicon single-crystal substrate and then implanting oxygen ions to a predetermined depth in the substrate from this mirror-processed surface, and a high-temperature heat treatment step of performing a high-temperature heat treatment to the substrate having the oxygen ion implanted therein in an oxidizing atmosphere to form a buried oxide layer in the substrate. Specifically, the silicon single-crystal substrate is maintained at a temperature of 500°C to 650°C, and approximately 10¹⁷ to 10¹⁸/cm² of an oxygen atom ion or an oxygen molecule ion is implanted to a predetermined depth from the substrate front surface. Subsequently, the silicon substrate having the oxygen ion implanted therein is put into a heat treatment furnace in which a temperature is maintained at 500°C to 700°C, a gradual increase in the temperature is started so as not to produce slip, and a heat treatment is carried out at a temperature of approximately 1300°C to 1390°C for about 10 hours. This high-temperature heat treatment causes the oxygen ion implanted in the substrate to react with silicon, thereby forming a buried oxide layer in the substrate.

On the other hand, in a device manufacturing process, as a gettering technology of removing a metal that directly adversely affects device characteristics from a substrate front surface, there is an external gettering method, e.g., a method of finding a strain by using sandblast on a substrate rear surface, a method of depositing a polycrystal silicon film on a substrate rear surface, or a method of implanting high-concentration phosphor into a substrate rear surface, but an intrinsic gettering method that utilizes a strain field of a crystal defect due to an oxide precipitate that is precipitated in a silicon substrate is used in part of mass production as a clean gettering method superior in mass productivity.
However, in general, since the SIMOX substrate requires a high-temperature heat treatment at approximately 1300°C after oxygen ion implantation in order to form a buried oxide layer in the substrate, it is said that forming an oxygen precipitate as an intrinsic gettering sink in a bulk layer based on this high-temperature heat treatment is difficult.

As a measure that solves this problem, a semiconductor substrate manufacturing method of implanting oxygen ions into a silicon single-crystal substrate, performing a heat treatment to the substrate in a hydrogen atmosphere or a nitrogen atmosphere including a small amount of oxygen at a temperature of 1200 to 1300°C for 6 to 12 hours to form a buried oxide layer, and then gradually or continuously increasing a temperature from a low temperature to a high temperature to carry out the heat treatment is proposed (see, e.g., Patent Document 1). As specific heat treatment conditions explained in this Patent Document 1, the gradual heat treatment method is described as a method of sequentially increasing a temperature from 500°C in increments of 50 to 100°C and setting a final temperature to 850°C, and the continuous heat treatment method is described as a method of increasing a temperature from 500°C with a gradient of 0.2 to 1.0°C/min and setting a final temperature to 850°C. However, since reduction and annihilation of an oxide precipitate nucleus due to pulling up a crystal occurs when a high-temperature heat treatment at approximately 1300°C is performed to form a buried oxide layer in a SIMOX substrate, growth of each oxide precipitate is suppressed under heat treatment conditions explained in Patent Document 1, and hence a sufficient gettering effect cannot be obtained when a finally reached temperature is 850°C.

Further, a SIMOX substrate having a structure where a region in which a buried oxide layer is not partially formed is provided and gettering means based on a crystal defect or a crystal distortion is provided on a silicon single-crystal substrate bulk or a silicon single-crystal rear surface, and a manufacturing method thereof are proposed (see, e.g., Patent Document 2). In this Patent Document 2 is described that a buried oxide layer is formed in fragments near a surface layer, each oxide precipitate nucleus may be formed under a heat treatment condition for gettering in the range of 500 to 900°C, its density falls in the range of 10⁵ pieces/cm³ to 10⁹ pieces/cm³, and the precipitate nucleus may be grown into a precipitate in the range of 1000 to 1150°C as a second heat treatment.

However, in examples, a SIMOX according to a conventional technology, i.e., a SIMOX having a buried oxide film grown on an entire wafer surface is determined as a reference sample and a crystal defect generation quantity on the substrate surface due to quantitative contamination of a heavy metal is evaluated, but a surface defect is rarely observed in an example of a partially buried oxide film, whereas pits and stacking faults having a density of 10⁵ to 10⁶ pieces/cm² are observed in the conventional SIMOX. That is, this means that a perfect gettering technology is not established in Patent Document 1.
Patent Document 1: Japanese Patent Application Laid-open No. 193072-1995 (claims 1 to 3)
Patent Document 2: Japanese Patent Application Laid-open No. 82525-1993 (claims 1, 2, 4, and 5, paragraph [0019] to paragraph [0023])
Nonpatent Literature 1: J. Electrochem. Soc., 142,2059, (1995)

### DISCLOSURE OF INVENTION

### PROBLEM TO BE SOLVED BY THE INVENTION

On the other hand, as characteristics when manufacturing a SIMOX substrate, a structure where a defect aggregate layer having a thickness of approximately 200 nm is necessarily formed immediately below a buried oxide layer is disclosed, the defect aggregate layer having a gettering effect (see, e.g., Nonpatent Literature 1). That is, based on contents disclosed in Nonpatent Literature 1, when heavy metal contamination extemporaneously occurs in a manufacturing process of the SIMOX substrate, it can be considered that a heavy metal is also trapped in the defect aggregate layer immediately below the buried oxide layer if the oxide precipitates described in Patent Document 1 or Patent Document 2 cannot obtain the sufficient gettering effect.

Further, since a reduction in thickness of an SOI layer in the SIMOX substrate is demanded in recent years, a region of the heavy metal contamination trapped in the defect aggregate layer immediately below the buried oxide layer may possibly affect device characteristics, and designing a SIMOX substrate which does not affect at least device characteristics and has a gettering source that can efficiently trap unexpected heavy metal contamination in the process is required.

It is an object of the present invention to provide a method of manufacturing a SIMOX substrate and a SIMOX substrate obtained by this method that can reduce a heavy metal trapping concentration of a defect aggregate layer and efficiently trap a heavy metal in a bulk layer.

### MEANS FOR SOLVING PROBLEM

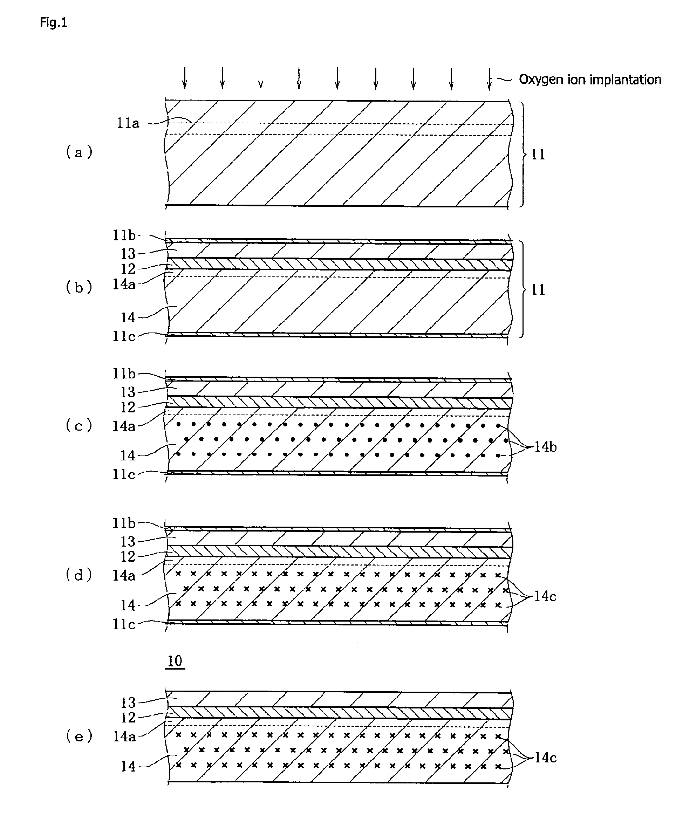

As shown in FIGS. 1(a) to 1(e), the invention according to claim 1 is an improvement in a method of manufacturing a SIMOX substrate, comprising: a step of implanting oxygen ions into a silicon wafer 11; and a step of performing a first heat treatment to the wafer 11 in a mixed gas atmosphere of oxygen and an inert gas at 1300 to 1390°C to form a buried oxide layer 12 in a region having a predetermined depth from a front surface of the wafer 11 and also form an SOI layer 13 on the buried oxide layer 12.
Its characteristic structure lies in that the silicon wafer 11 before the oxygen ion implantation has an oxygen concentration of 8×10¹⁷ to 1.8×10¹⁸ atoms/cm³ (old ASTM), the buried oxide layer 12 is formed over the entire wafer surface, and the method includes: a step of performing a second heat treatment to the wafer subjected to the first heat treatment in oxygen, nitrogen, argon, hydrogen, or a mixed gas atmosphere containing these components at 400 to 900°C for 1 to 96 hours to form oxide precipitate nuclei 14b in a bulk layer 14 below a defect aggregate layer 14a formed immediately below the buried oxide layer 12; and a step of performing a third heat treatment to the wafer subjected to the second heat treatment in oxygen, nitrogen, argon, hydrogen, or a mixed gas atmosphere containing these components at 900 to 1250°C higher than the second heat treatment temperature for 1 to 96 hours to grow the oxide precipitate nuclei 14b formed in the bulk layer 14 into oxide precipitates 14c.
According to the invention defined in claim 1, it is possible to obtain the SIMOX substrate in which a gettering source consisting of the oxide precipitates 14c is provided in the bulk layer 14 below the defect aggregate layer 14a, a density of the oxide precipitates 14c is 1×10⁸ to 1×10¹² pieces/cm³, and sizes of the oxide precipitates 14c are 50 nm or above.

The invention defined in claim 2 provides, as the invention according to claim 1, the manufacturing method, wherein the second heat treatment is carried out in the range of 1 to 96 hours by increasing a temperature in a part or all of the range of 400°C to 900°C at a speed of 0.1 to 5.0°C/minute, and the third heat treatment is performed in the range of 1 to 96 hours by increasing a temperature in a part or all of the range of 900°C to 1250°C at a speed of 0.1 to 20°C/minute .

The invention according to claim 3 is an improvement in a method of manufacturing a SIMOX substrate, comprising: a step of implanting oxygen ions into a silicon wafer 11; and a step of performing a first heat treatment to the wafer 11 in a mixed gas atmosphere of oxygen and an inert gas at 1300 to 1390°C to form a buried oxide layer 12 in a region having a predetermined depth from a front surface of the wafer 11 and also form an SOI layer 13 on the wafer front surface above the buried oxide layer 12.
Its characteristic structure lies in that the silicon wafer 11 before the oxygen ion implantation has an oxygen concentration of 8x10¹⁷ to 1.8x10¹⁸ atoms/cm³ (old ASTM), the buried oxide layer 12 is formed on a part or all of the entire wafer surface, and the method includes: a step of performing a rapid heat treatment of maintaining the wafer subjected to the first heat treatment at 1050 to 1350°C for 1 to 900 seconds and then reducing the temperature at a temperature-down speed of 10°C/second or above to implant vacancies into a bulk layer 14 below the buried oxide layer 12, and a step of performing a second heat treatment to the wafer subjected to the rapid heat treatment in oxygen, nitrogen, argon, hydrogen, or a mixed gas atmosphere containing these components at 500 to 1000°C for 1 to 96 hours to form oxide precipitate nuclei 14b in the bulk layer 14 below a defect aggregate layer 14a formed immediately below the buried oxide layer 12.
In the invention according to claim 3, when the SIMOX substrate subjected to the second heat treatment is subjected to a heat treatment in a device manufacturing process of a semiconductor device manufacturer, the oxide precipitate nuclei grow into oxide precipitates, thereby providing an IG effect on the entire wafer surface.

The invention according to claim 4 provides, as the invention according to claim 3, the manufacturing method further comprising a step of performing a third heat treatment to the wafer subjected to the second heat treatment in oxygen, nitrogen, argon, hydrogen, or a mixed gas atmosphere containing these components at 900 to 1250°C higher than the second heat treatment temperature for 1 to 96 hours to grow the oxide precipitate nuclei 14b formed in the bulk layer 14 into oxide precipitates 14c.
The invention according to claim 5 provides, as the invention according to claim 3, the manufacturing method wherein the second heat treatment is carried out in the range of 1 to 96 hours by increasing a temperature in a part or all of the range of 500°C to 1000°C at a speed of 0.1 to 5.0°C/minute.
The invention according to claim 6 provides, as the invention according to claim 4, the manufacturing method wherein the third heat treatment is carried out in the range of 1 to 96 hours by increasing a temperature in a part or all of the range of 900°C to 1250°C at a speed of 0.1 to 20°C/minute.

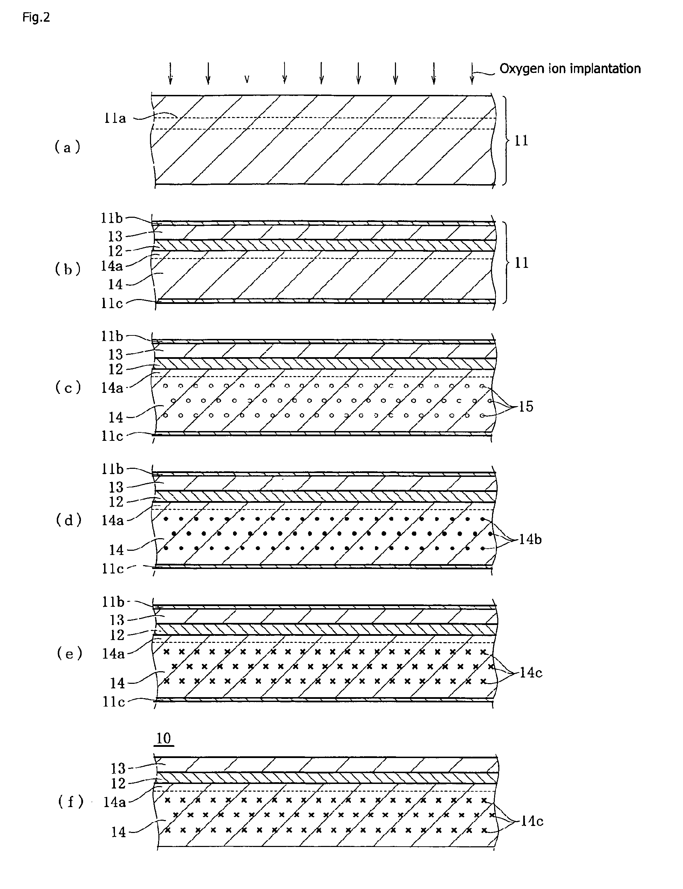

As shown in FIG. 1(e) or FIG. 2(f), the invention according to claim 7 provides a SIMOX substrate manufactured by the method according to any one of claims 1 to 6, comprising: a buried oxide layer 12 formed in a region having a predetermined depth from a wafer front surface; an SOI layer 13 formed on the wafer front surface above the buried oxide layer; a defect aggregate layer 14a formed immediately below the buried oxide layer 12; and a bulk layer 14 below the buried oxide layer 12, wherein a gettering source consisting of oxide precipitates 14c is provided in the bulk layer 14 below the defect aggregate layer 14a, a density of the oxide precipitates 14c is 1×10⁸ to 1×10¹² pieces/cm³, and sizes of the oxide precipitates 14c are 50 nm or above.
In the invention according to claim 7, the gettering source consisting of the oxide precipitates 14 is provided in the bulk layer 14 below the defect aggregate layer 14a, the density of the oxide precipitates 14c is 1×10⁸ to 1×10¹² pieces/cm³, and the gettering source stronger than the defect aggregate layer 14a can be provided since the size of each oxide precipitate 14c is 50 nm or above, thereby gettering almost all of the heavy metal contamination conventionally trapped in the defect aggregate layer 14a into the oxide precipitates 14c in the bulk layer 14 without trapping in the defect aggregate layer.

### EFFECT OF THE INVENTION

In the SIMOX substrate according to the present invention, since the gettering source consisting of the oxide precipitates is provided in the bulk layer below the defect aggregate layer, the density of the oxide precipitate is 1×10⁸ to 1×10¹² pieces/cm³, and the size of each oxide precipitate is 50 nm or above, the gettering source stronger than the defect aggregate layer can be provided, thus reducing the heavy metal trapping concentration of the defect aggregate layer and efficiently trapping the heavy metal in the bulk layer.

### BRIEF DESCRIPTION OF DRAWINGS

FIG. 1 is a process drawing showing a first manufacturing method of a SIMOX substrate according to the present invention; and
FIG. 2 is a process drawing showing a second manufacturing method of a SIMOX substrate according to the present invention.

### EXPLANATIONS OF LETTERS OR NUMERALS

- 10: SIMOX substrate
- 11: silicon wafer
- 12: buried oxide layer
- 13: SOI layer
- 14: bulk layer
- 14a: defect aggregate layer
- 14b: oxide precipitate nucleus
- 14c: oxide precipitate
- 15: vacancy

### BEST MODES FOR CARRYING OUT THE INVENTION

A first embodiment for carrying out the present invention will now be explained hereinafter with reference to the drawings.
The present invention relates to a SIMOX substrate having a structure where a buried oxide layer is formed in a region having a predetermined depth from a wafer front surface by performing a heat treatment after implanting oxygen ions into a silicon wafer and an SOI layer is formed on the wafer front surface. Further, as shown in FIG. 1, according to a method of manufacturing a SIMOX substrate of the present invention, a wafer 11 after oxygen ion implantation is subjected to heat treatments on three stages, and then oxide films 11b and 11c formed on surfaces of the wafer 11 are removed. The respective steps will now be explained hereinafter.

### (1-1) Oxygen Ion Implantation Step

First, as shown in FIG. 1(a), a silicon wafer 11 is prepared, and oxygen ions are implanted into this wafer 11. As the silicon wafer 11 to be prepared before oxygen ion implantation, one having an oxygen concentration of 8x10¹⁷ to 1.8x10¹⁸ atoms/cm³ (old ASTM) is prepared. This silicon wafer to be prepared may be an epitaxial wafer or an annealed wafer.

Furthermore, the oxygen ion is implanted into such a prepared silicon wafer 11. This oxygen ion implantation is carried out by the same means as conventional means. Moreover, the oxygen ion is implanted into a region 11a having a predetermined depth from a front surface of the wafer 11 in such a manner that a thickness of an SOI layer 13 in the finally obtained SIMOX substrate becomes 10 to 200 nm, or preferably 20 to 100 nm. The thickness of the SOI layer 13 is hard to be controlled when the thickness of the SOI layer 13 is less than 10 nm, and an accelerating voltage of an oxygen ion implantation machine has a trouble when the thickness of the SOI layer 13 exceeds 200 nm.

### (1-2) First Heat Treatment Step

Then, as shown in FIG. 1(b), the wafer 11 having the oxygen ion implanted therein is subjected to a first heat treatment in a mixed gas atmosphere of oxygen and an inert gas at a temperature of 1300 to 1390°C. As the inert gas, there is an argon gas or a nitrogen gas. Therefore, it is preferable for the gas atmosphere of this first heat treatment to be a mixed gas of oxygen and argon or a mixed gas of oxygen and nitrogen. Moreover, it is desirable for this first heat treatment to have a heat treatment time of 1 to 20 hours, or preferably 10 to 20 hours.
Oxide films 11b and 11c are formed on the front surface and a rear surface of the wafer 11 by this first heat treatment, and a buried oxide layer 12 is formed in the region 11a having a predetermined depth from the front surface of the wafer 11 over the entire surface of the wafer. Additionally, an SOI layer 13 is formed between the oxide film 11b on the front side and the buried oxide layer 12. Further, a defect aggregate layer 14a is necessarily formed immediately below the buried oxide layer 12.

### (1-3) Second Heat Treatment Step

Then, as shown in FIG. 1(c), the wafer 11 which has been through the first heat treatment is subjected to a second heat treatment in a oxygen, nitrogen, argon, hydrogen, or a mixed gas atmosphere of these components in a state where the oxide films 11b and 11c are left or a state where the oxide films 11b and 11c are removed. When the second heat treatment is performed in the state where the oxide films 11b and 11c are left, a thickness of the SOI layer 13 is not reduced or changed in a non-oxidizing gas atmosphere in particular, which is preferable. That is because, firstly, the oxide films 11b and 11c further grow and silicon in the wafer surface is thereby consumed when the second heat treatment is effected in an oxidizing gas atmosphere and, secondly, the SOI layer 13 is etched when the second heat treatment is performed in hydrogen or an argon gas atmosphere. On the other hand, when the thickness of the SOI layer 13 is relatively large, the SOI layer 13 having a predetermined thickness can be obtained even if the thickness of the SOI layer 13 is reduced, and hence the second heat treatment may be carried out in the state where the oxide films 11b and 11c are removed. As the gas atmosphere of this second heat treatment, a nitrogen gas, an argon gas or nitrogen or an argon gas having a small amount of oxygen added thereto is preferable.

Further, as the second heat treatment conditions, the second heat treatment is performed at a temperature of 400 to 900°C for 1 to 96 hours. The temperature of the second heat treatment is restricted to the range of 400 to 900°C because a nucleus forming temperature becomes too low and a long-time heat treatment is required when a temperature is less than the lower limit value, and an oxide precipitate nucleus cannot be formed when the temperature exceeds the upper limit value. Furthermore, the second heat treatment time is restricted to fall within the range of 1 to 96 hours because a time required to form an oxide precipitate nucleus is too short when the time is less than the lower limit value, and productivity is degraded when the time exceeds the upper limit value. It is more preferable to perform this second heat treatment at a temperature of 500 to 800°C for 4 to 35 hours. Moreover, the second heat treatment may be performed for 1 to 96 hours, or preferably 4 to 35 hours by increasing a temperature in a part or all of the range of 400°C to 900°C at a speed of 0.1 to 5.0°C/minute, or preferably 0.1 to 1.0°C/minute. When this second heat treatment is effected, each oxide precipitate nucleus 14b is formed in the bulk layer 14 below the defect aggregate layer 14a formed immediately below the buried oxide layer 12.

### (1-4) Third Heat Treatment Step

Then, as shown in FIG. 1(d), the wafer 11 which has been through the second heat treatment is subjected to a third heat treatment. This third heat treatment is performed in oxygen, nitrogen, argon, hydrogen, or a mixed gas atmosphere of these components at 900 to 1250°C higher than the second heat treatment temperature for 1 to 96 hours. As the gas atmosphere of this third heat treatment, a nitrogen gas, an argon gas, or nitrogen or an argon gas having a small amount of oxygen added thereto is preferable. The third heat treatment temperature is restricted to the range of 900 to 1250°C because growth of an oxide precipitate nucleus does not sufficiently occur when the temperature is less than the lower limit value and an inconvenience, i.e., dissolution of an oxide precipitate occurs when the temperature exceeds the upper limit value. Further, the third heat treatment time is restricted to the range of 1 to 96 hours because growth of the oxide precipitate does not become sufficient when the time is less than the lower limit value and an inconvenience, i.e., degradation in productivity occurs when the time exceeds the upper limit value. Furthermore, it is desirable for the third heat treatment to be performed at 1000 to 1200°C for 8 to 24 hours. Moreover, the third heat treatment may be carried out for 1 to 96 hours, or preferably 8 to 24 hours by increasing a temperature in a part or all of the range of 900°C to 1250°C at a speed of 0.1 to 20°C/minute, or preferably 1 to 5°C/minute. When this third heat treatment is carried out, each oxide precipitate nucleus 14b formed in the bulk layer 14 can be grown into an oxide precipitate 14c.

### (1-5) Step of Removing Oxide Films 11b and 11c

As shown in the last FIG. 1(e), the oxide films 11b and 11c on the front surface and the rear surface of the wafer 11 subjected to the third heat treatment are removed by using, e.g., a fluorinated acid. As a result, there can be obtained a SIMOX substrate which includes the buried oxide layer 12 formed in the region having the predetermined depth from the front surface of the wafer, the SOI layer 13 formed on the wafer front surface above the buried oxide layer, the defect aggregate layer 14a formed immediately below the buried oxide layer 12, and the bulk layer 14 below the buried oxide layer 12, and has a gettering source consisting of the oxide precipitates 14c in the bulk layer 14 below the defect aggregate layer 14a, the SIMOX substrate being characterized in that a density of the oxide precipitates 14c is 1×10⁸ to 1×10¹² pieces/cm³ and a size of each oxide precipitate 14c is 50 nm or above.

In this SIMOX substrate, since the bulk layer 14 below the defect aggregate layer 14a has the oxide precipitates 14c whose density is 1×10⁸ to 1×10¹² pieces/cm³ and whose size is 50 nm or above, sudden heavy metal contamination in a device process can be efficiently trapped by the oxide precipitates 14c. Additionally, since this oxide precipitate 14c serves as a gettering source stronger than the defect aggregate layer 14a, the heavy metal contamination conventionally trapped in the defect aggregate layer 14a can be gettered in each oxide precipitate 14c in the bulk layer 14. As a result, when the substrate is forcibly contaminated with a heavy metal in such a manner that a heavy metal concentration becomes 1×10¹¹ to 1×10¹² pieces/cm², the concentration of the heavy metal trapped in the defect aggregate layer 14a can be reduced to a level of 5×10⁹ pieces/cm² or below. It is needless to say that the present invention can be also applied to a SIMOX substrate in which a buried oxide layer is partially formed.

A second embodiment for carrying out the present invention will now be explained with reference to the drawings.
The present invention relates to a SIMOX substrate having a structure where oxygen ions are implanted into a silicon wafer, then a heat treatment is carried out to form a buried oxide layer in a region having a predetermined depth from a wafer front surface, and an SOI layer is formed on the wafer front surface. Further, as shown in FIG. 2, according to a method of manufacturing a SIMOX substrate of the present invention, a wafer 11 having the oxygen ion implanted therein is subjected to heat treatments on three stages or four stages, and then oxide films 11b and 11c formed on surfaces of the wafer 11 are removed. Respective steps in this method will now be explained.

### (2-1) Oxygen Ion Implantation Step

First, as shown in FIG. 2(a), a silicon wafer 11 is prepared, and oxygen ions are implanted into this wafer 11. As the silicon wafer 11 to be prepared before oxygen ion implantation, one having an oxygen concentration of 8x10¹⁷ to 1.8x10¹⁸ atoms/cm³ (old ASTM) is prepared. This silicon wafer to be prepared may be an epitaxial wafer or an annealed wafer.

Furthermore, the oxygen ion is implanted into such a prepared silicon wafer 11. Implantation of this oxygen ion is carried out by the same means as conventionally adopted means. Moreover, the oxygen ion is implanted into a region 11a having a depth from a front surface of the wafer 11 in such a manner that a thickness of an SOI layer 13 in the finally obtained SIMOX substrate becomes 10 to 200 nm, or preferably 20 to 100 nm. Controlling a thickness of the SOI layer 13 is difficult when the thickness of the SOI layer is less than 10 nm, and a difficulty occurs in an accelerating voltage of an oxygen ion implantation machine when the thickness of the SOI layer 13 exceeds 200 nm.

It is to be noted that, when, e.g., a mask is partially formed at a desired position on the front surface of the silicon wafer 11 and then the oxygen ion is implanted into the silicon wafer 11, the oxygen ion is implanted into the wafer below a position where the mask is not formed and the oxygen ion is not implanted into the wafer below a position where the mask is formed, and hence a buried oxide layer 12 is partially formed below only the position where the mask is not formed by effecting a subsequent first heat treatment.

### (2-2) First Heat Treatment Step

Then, as shown in FIG. 2(b), the wafer 11 having the oxygen ion implanted therein is subjected to the first heat treatment in a mixed gas atmosphere containing oxygen and an inert gas at a temperature of 1300 to 1390°C. As the inert gas, there is an argon gas or a nitrogen gas. Therefore, as the gas atmosphere of this first heat treatment, a mixed gas of oxygen and argon or a mixed gas of oxygen and nitrogen is preferable. Moreover, as a heat treatment time of this first heat treatment, a period of 1 to 20 hours, or preferably a period of 10 to 20 hours is desirable.
The oxide films 11b and 11c are formed on the front surface and a rear surface of the wafer 11 by this first heat treatment, and the buried oxide layer 12 is formed in the region 11a having the predetermined depth from the front surface of the wafer 11 over the entire surface of the wafer. Additionally, when the oxygen ion is partially implanted in the region having the predetermined depth from the front surface of the wafer 11 by using, e.g., a mask, the buried oxide layer 12 is partially formed. Further, the SOI layer 13 is formed between the oxide film 11b on the front side and the buried oxide layer 12. Furthermore, a defect aggregate layer 14a is necessarily formed immediately below the buried oxide layer 12.

### (2-3) Rapid Heat Treatment Step

Subsequently, as shown in FIG. 2(c), the wafer subjected to the first heat treatment is maintained at 1050°C to 1350°C for 1 second to 900 seconds, and then a rapid heat treatment of reducing a temperature at a temperature-down speed of 10°C/second or above is performed. As a gas atmosphere of this rapid heat treatment, an argon gas or an ammonia containing gas atmosphere is preferable.

Moreover, as rapid heat treatment conditions, the wafer is maintained at 1050°C to 1350°C for 1 second to 900 seconds. The rapid heat treatment temperature is restricted to the range of 1050°C to 1350°C because vacancies a quantity of which is sufficient to promote formation of each oxide precipitate nucleus cannot be implanted into the wafer when the temperature is less than the lower limit value and slip dislocation occurs in the wafer during the heat treatment to obstruct manufacture of a device when the temperature exceeds the upper limit value, which is not preferable. A desirable heat treatment temperature is 1100 to 1300°C. Additionally, the maintaining time is set to 1 second to 900 seconds because there is a concern that a time required to reach a desired heat treatment reaching temperature varies depending on an surface and a depth direction of the wafer when the maintaining time is less than the lower limit value, resulting in a factor of unevenness in quality. Further, the upper limit value is restricted since a slip reduction and productivity are considered. A desirable maintaining time is 10 to 60 seconds. When the wafer is maintained at the rapid heat treatment temperature for a predetermined time, vacancies are implanted in the wafer, but a cooling speed when reducing a temperature of the wafer takes a key role in order to hold the implanted vacancies in the wafer. It is considered that the implanted vacancies disappear when they reach the wafer front surface, its concentration is lowered near the outermost surface, and external diffusion of the vacancies occurs from the inside toward the surface based on a concentration difference caused due to this reduction. Therefore, it can be considered that the holding time for the temperature reduction is prolong when the cooling speed is low, external diffusion thereby advances, and the vacancies implanted by a high-temperature RTA heat treatment are reduced, the vacancies a quantity of which is sufficient to form each oxide precipitate cannot be assured.

Therefore, the predetermined holding operation is carried out, and then the temperature is reduced at a temperature-down speed of 10°C/second or above. The temperature-down speed is restricted to 10°C/second or above because an effect of suppressing disappearance of the vacancies cannot be obtained when the temperature-down speed is less than the lower limit value. An upper limit value is not set because almost no change is observed in the effect when the temperature-down speed exceeds 10°C/second. However, when the temperature-down speed is set too high, wafer in-plane temperature uniformity is degraded during cooling and slip occurs, and hence controlling the temperature-down speed to 10 to 100°C/second while considering productivity is desirable. A more preferable temperature-down speed is 15 to 50°C/second. Performing this rapid heat treatment allows vacancies 15 to be implanted into the bulk layer 14 below the buried oxide layer 12. Based on this rapid heat treatment, in-plane uniformity of an oxide precipitate density distribution within a wafer plane can be assured, and assuredness of growth of the oxide precipitates can be improved even if the wafer is a silicon wafer having a low oxygen concentration. It is to be noted that, when this rapid heat treatment is not effected, the oxide precipitate density distribution in the wafer plane cannot be uniformed even though a subsequent step is carried out.

### (2-4) Second Heat Treatment Step

Then, as shown in FIG. 2(d), a second heat treatment is carried out with respect to the wafer 11 subjected to the rapid heat treatment in oxygen, nitrogen, argon, hydrogen, or a mixed gas atmosphere containing these components in a state where the oxide films 11b and 11c are left or in a state where the oxide films 11b and 11c are removed. When the second heat treatment is performed in the state where the oxide films 11b and 11c are left, a thickness of the SOI layer 13 is not reduced or changed in a non-oxidizing gas atmosphere in particular, which is preferable. That is because, firstly, the oxide films 11b and 11c further grow and silicon in the wafer surface is thereby consumed when the second heat treatment is effected in an oxidizing gas atmosphere and, secondly, the SOI layer 13 is etched when the second heat treatment is carried out in hydrogen or an argon gas atmosphere. On the other hand, when the thickness of the SOI layer 13 is relatively large, since the SOI layer 13 having a predetermined thickness can be obtained even if the thickness of the SOI layer 13 is reduced, and hence the second heat treatment may be carried out in the state where the oxide films 11b and 11c are removed. As the gas atmosphere of this second heat treatment, a nitrogen gas, an argon gas, or nitrogen or an argon gas having a small amount of oxygen added thereto is preferable.

Furthermore, as second heat treatment conditions, the second heat treatment is performed at a temperature of 500 to 1000°C for 1 to 96 hours. The second heat treatment temperature is restricted to the range of 500 to 1000°C because a nucleus forming temperature is too low and a long-time heat treatment is required when the temperature is less than the lower limit value and an oxide precipitate nucleus is not formed when the temperature exceeds the upper limit value. Moreover, the second heat treatment time is restricted to the range of 1 to 96 hours because a time required to form an oxide precipitate nucleus is too short when the time is less than the lower limit value and an inconvenience, i.e., degradation in productivity occurs when the time exceeds the upper limit value. It is further desirable for the second heat treatment to be effected at a temperature of 500 to 800°C for 4 to 35 hours. Additionally, the second heat treatment may be performed in the range of 1 to 96 hours, or preferably 4 to 35 hours by increasing a temperature in a part of all of the range of 500°C to 1000°C at a speed of 0.1 to 5.0°C/minute, or preferably 0.1 to 1.0°C/minute. When this second heat treatment is effected, the oxide precipitate nuclei 14b are formed in the bulk layer 14 below the defect aggregate layer 14a formed immediately below the buried oxide layer 12. When the SIMOX substrate which has been through this second heat treatment is subjected to a heat treatment in a device manufacturing process of a semiconductor device manufacturer, each oxide precipitate nucleus grows into an oxide precipitate, thereby demonstrating an IG effect over the entire wafer surface.

### (2-5) Third Heat Treatment Step

Subsequently, as shown in FIG. 2(e), the wafer 11 which has been through the second heat treatment is subjected to a third heat treatment. This third heat treatment is effected in oxygen, nitrogen, argon, hydrogen, or a mixed gas atmosphere containing these components at 900 to 1250°C higher than the second heat treatment temperature for 1 to 96 hours. As the gas atmosphere of this third heat treatment, a nitrogen gas, an argon gas, or a nitrogen or an argon gas having a small amount of oxygen added thereto is preferable. The third heat treatment temperature is restricted to the range of 900 to 1250°C because growth of an oxide precipitate nucleus is hard to sufficiently occur when the temperature is less than the lower limit value and an inconvenience, i.e., dissolution of an oxide precipitate occurs when the temperature exceeds the upper limit value. Moreover, the third heat treatment time is restricted to the range of 1 to 96 hours because growth of each oxide precipitate does not become sufficient when the time is less than the lower limit value and an inconvenience, i.e., degradation in productivity occurs when the time exceeds the upper limit value. Additionally, it is preferable for the third heat treatment to be carried out at 1000 to 1200°C for 8 to 24 hours. Further, the third heat treatment may be effected for 1 to 96 hours, or preferably 8 to 24 hours by increasing a temperature in a part or all of the range of 900°C to 1250°C at a speed of 0.1 to 20°C/minute, or preferably 1 to 5°C/minute. When this third heat treatment is effected, the oxide precipitate nuclei 14b formed in the bulk layer 14 can be grown into the oxide precipitates 14c.

### (2-6) Step of Removing Oxide Films 11b and 11c

As shown in the last FIG. 2(f), the oxide films 11b and 11c formed on the front surface and the rear surface of the wafer 11 subjected to the third heat treatment are removed by using, e.g., a fluorinated acid. As a result, it is possible to obtain the SIMOX substrate which includes the buried oxide layer 12 formed in the region having the predetermined depth from the wafer front surface, the SOI layer 13 formed on the wafer front surface above the buried oxide layer, the defect aggregate layer 14a formed immediately below the buried oxide layer 12, and the bulk layer 14 below the buried oxide layer 12, and has a gettering source consisting of the oxide precipitates 14c in the bulk layer 14 below the defect aggregate layer 14a, and has a configuration where a density of the oxide precipitates 14c is 1×10⁸ to 1x10¹² pieces/cm³ and a size of each oxide precipitate 14c is 50 nm or above.

In this SIMOX substrate, since the bulk layer 14 below the defect aggregate layer 14a has the oxide precipitates 14c whose density is 1×10⁸ to 1×10¹² pieces/cm³ and whose size is 50 nm or above, sudden heavy metal contamination during a device process can be efficiently trapped in these oxide precipitates 14c. Furthermore, the oxide precipitates 14c serve as a gettering source stronger than the defect aggregate layer 14a, and hence the heavy metal contamination conventionally trapped in the defect aggregate layer 14a can be gettered in the oxide precipitates 14c in the bulk layer 14. As a result, for example, when the substrate is forcibly contaminated with a heavy metal in such a manner that a heavy metal concentration becomes 1×10¹¹ to 1×10¹² pieces/cm², a concentration of the heavy metal trapped in the defect aggregate layer 14a can be reduced to a level of 5×10⁹ pieces/cm² or below.

### Examples

Examples according to the present invention as well as comparative examples will now be explained hereinafter in detail.

### <Example 1>

First, as shown in FIG. 1(a), a CZ silicon wafer sliced with a predetermined thickness from a silicon ingot which was grown by a CZ method and has an oxygen concentration of 1.3×10¹⁸ atoms/cm³ (old ASTM) and a specific resistance of 20 Ω·cm was prepared. Then, this wafer was heated to a temperature of 550°C, and oxygen ions were implanted into a predetermined region (e.g., a region which is approximately 0.4 µm from a substrate front surface) of the silicon wafer in this state under the following conditions.

Accelerating voltage: 180 keV
Beam current: 50 mA
Dose amount: 4×10¹⁷/cm²
After ion implantation, SC-1 and SC-2 cleaning was carried out with respect to wafer surfaces. Subsequently, as shown in FIG. 1(b), there was carried out a first heat treatment of putting the wafer 11 into a heat treatment furnace, maintaining the wafer 11 in an Ar gas atmosphere having an oxygen partial pressure of 0.5% at a fixed temperature of 1350°C for 4 hours, then increasing the oxygen partial pressure of the in-furnace atmosphere to 70%, and further maintaining the wafer 11 for 4 hours. As shown in FIG. 1(c), there was performed a second heat treatment of continuously increasing a temperature of this wafer subjected to the first heat treatment in a 1% oxygen atmosphere from 500°C to 850°C at 1.0°C/minute in a state where oxide films 11b and 11c on the surfaces are left and then maintaining the wafer at 850°C for 1 hour. As shown in FIG. 1(d), there was effected a third heat treatment of increasing a temperature of the wafer 11 subjected to this second heat treatment in the 1% oxygen atmosphere from 850°C to 1100°C at a temperature-up speed of 5.0°C/minute and then maintaining the wafer 11 at 1100°C for 8 hours. Subsequently, a temperature of the wafer subjected to this third heat treatment was reduced to 700°C at a temperature-down speed of 3.0°C/minute. The oxide films 11b and 11c on the front surface and the rear surface of the wafer subjected to the heat treatments were removed by using an HF solution, thereby obtaining a SIMOX substrate. This SIMOX substrate was determined as Example 1.

### <Example 2>

First, as shown in FIG. 1(a), a CZ silicon wafer sliced with a predetermined thickness from a silicon ingot which was grown by a CZ method and has an oxygen concentration of 1.4×10¹⁸ atoms/cm³ (old ASTM), a nitrogen concentration of 4.0×10¹⁴ atoms/cm³ (old ASTM), and a specific resistance of 10 Ω·cm was prepared. Then, this wafer was heated to a temperature of 550°C, and oxygen ions were implanted into a predetermined region (e.g., a region which is approximately 0.4 µm from a substrate front surface) of the silicon wafer in this state under the following conditions.

Accelerating voltage: 180 keV
Beam current: 50 mA
Dose amount: 4×10¹⁷/cm²
After ion implantation, SC-1 and SC-2 cleaning was carried out with respect to wafer surfaces. Subsequently, as shown in FIG. 1(b), there was carried out a first heat treatment of putting the wafer 11 into a heat treatment furnace, maintaining the wafer 11 in an Ar gas atmosphere having an oxygen partial pressure of 0.5% at a fixed temperature of 1350°C for 4 hours, then increasing the oxygen partial pressure of the in-furnace atmosphere to 70%, and further maintaining the wafer 11 for 4 hours. As shown in FIG. 1(c), there was performed a second heat treatment of continuously increasing a temperature of this wafer subjected to the first heat treatment in a 1% oxygen (argon-based) atmosphere from 600°C to 700°C at 0.5°C/minute in a state where oxide films 11b and 11c on the surfaces are left and then maintaining the wafer at 700°C for 1 hour. As shown in FIG. 1(d), there was effected a third heat treatment of increasing a temperature of the wafer 11 subjected to this second heat treatment in the 1% oxygen atmosphere from 700°C to 1000°C at a temperature-up speed of 5.0°C/minute and then maintaining the wafer 11 at 1000°C for 16 hours. Subsequently, a temperature of the wafer subjected to this third heat treatment was reduced to 700°C at a temperature-down speed of 3.0°C/minute. The oxide films 11b and 11c on the front surface and the rear surface of the wafer subjected to the heat treatments were removed by using an HF solution, thereby obtaining a SIMOX substrate. This SIMOX substrate was determined as Example 2.

### <Example 3>

A SIMOX substrate was obtained like Example 2 except that a wafer was maintained at 700°C for 4 hours as a second heat treatment. This SIMOX substrate was determined as Example 3.

### <Example 4>

A SIMOX substrate was obtained like Example 2 except that a wafer was maintained at 700°C for 8 hours as a second heat treatment. This SIMOX substrate was determined as Example 4.

### <Example 5>

First, as shown in FIG. 1(a), a CZ silicon wafer sliced with a predetermined thickness from a silicon ingot which was grown by a CZ method and has an oxygen concentration of 1.4×10¹⁸ atoms/cm³ (old ASTM), a nitrogen concentration of 2.02×10¹⁶ atoms/cm³ (old ASTM), and a specific resistance of 10 Ω·cm was prepared. A silicon epitaxial film with a thickness of 3 µm was deposited on a surface of this CZ silicon wafer. Then, this wafer was heated to a temperature of 550°C, and oxygen ions were implanted into a predetermined region (e.g., a region which is approximately 0.4 µm from a substrate front surface) of the silicon wafer in this state under the following conditions.

Accelerating voltage: 180 keV
Beam current: 50 mA
Dose amount: 4×10¹⁷/cm²
After ion implantation, SC-1 and SC-2 cleaning was carried out with respect to wafer surfaces. Subsequently, as shown in FIG. 1(b), there was carried out a first heat treatment of putting the wafer 11 into a heat treatment furnace, maintaining the wafer 11 in an Ar gas atmosphere having an oxygen partial pressure of 0.5% at a fixed temperature of 1350°C for 4 hours, then increasing the oxygen partial pressure of the in-furnace atmosphere to 70%, and further maintaining the wafer 11 for 4 hours. As shown in FIG. 1(c), there was performed a second heat treatment of maintaining the wafer subjected to this first heat treatment in a nitrogen atmosphere at 700°C for 8 hours in a state where oxide films 11b and 11c on the surfaces are left. As shown in FIG. 1(d), there was effected a third heat treatment of increasing a temperature of the wafer 11 subjected to this second heat treatment in the nitrogen atmosphere from 700°C to 1000°C at a temperature-up speed of 5.0°C/minute and then maintaining the wafer 11 at 1000°C for 16 hours. Subsequently, a temperature of the wafer subjected to this third heat treatment was reduced to 700°C at a temperature-down speed of 3.0°C/minute. The oxide films 11b and 11c on the front surface and the rear surface of the wafer subjected to the heat treatments were removed by using an HF solution, thereby obtaining a SIMOX substrate. This SIMOX substrate was determined as Example 5.

### <Comparative Example 1>

A SIMOX substrate was obtained like Example 1 except that the second heat treatment and the third heat treatment are not performed. This SIMOX substrate was determined as Comparative Example 1.

### <Comparative Example 2>

A SIMOX substrate was obtained like Example 1 except that a heat treatment of starting increasing a temperature from 500°C and continuously increasing the temperature at 1.0°C/minute until a finally reached temperature becomes 850°C was performed in place of the second heat treatment and the third heat treatment. This SIMOX substrate was determined as Comparative Example 2.

### <Comparative Test 1>

After removing the surface oxide films 11b and 11c of each SIMOX substrate 10 according to each of Examples 1 to 5 and Comparative Examples 1 and 2, an SOI layer 13, a buried oxide layer 12, and a defect aggregate layer 14a immediately below the buried oxide layer in each SIMOX substrate were respectively dissolved and collected by using a fluorinated acid/nitric acid aqueous solution, and these collected dissolved liquids were subjected to ICP-MS measurement (Inductively Coupled Plasma-Mass Spectrometry) to measure heavy metal concentrations of iron, nickel, zinc, and copper contained in the dissolved liquids. Further, each bulk layer 14 according to each of Example 1 to 5 and Comparative Examples 1 and 2 was completely dissolved, and a heavy metal concentration in the completely dissolved liquid was measured.

The heavy metals except nickel, i.e., iron, zinc, and copper were not observed in the SOI layers, the buried layers, the defect aggregate layers, and the bulk layers in all the SIMOX substrates according to Examples 1 to 5 and Comparative Examples 1 and 2. Table 1 shows results of concentrations of nickel contained in the respective layers of the SIMOX substrates according to Examples 1 to 5 and Comparative Examples 1 and 2.

**[Table 1]**

| | Nickel concentration [atoms/cm²] | | | [atoms/cm³] |
|---|---|---|---|---|
| | SOI layer | Buried oxide layer | Defect aggregate layer | Bulk layer |
| Example 1 | <5.0×10⁹ | <5.0×10⁹ | <5.0×10⁹ | 2.6×10¹¹ to 4.8×10¹¹ |
| Example 2 | <5.0×10⁹ | <5.0×10⁹ | <5.0×10⁹ | |
| Example 3 | <5.0×10⁹ | <5.0×10⁹ | <5.0×10⁹ | |
| Example 4 | <5.0×10⁹ | <5.0×10⁹ | <5.0×10⁹ | |
| Example 5 | <5.0×10⁹ | <5.0×10⁹ | <5.0×10⁹ | |
| Comparative Example 1 | 5.0×10¹⁰ | 5.0×10¹⁰ | 5.0×10¹⁰ | <1.0×10¹¹ |
| Comparative Example 2 | 5.0×10¹⁰ | 5.0×10¹⁰ | 5.0×10¹⁰ | <1.0×10¹¹ |

As apparent from Table 1, in each of the SIMOX substrates according to Comparative Examples 1 and 2, nickel having a concentration of approximately 5.0×10¹⁰ atoms/cm² converted to a surface concentration was observed in each of the SOI layer, the buried oxide layer, and the defect aggregate layer. On the other hand, the nickel concentration in the bulk layer was equal to or below a detection limit value. On the other hand, in each of the SIMOX substrates according to Examples 1 to 5, the nickel concentration was equal to or below the detection limit value in each of the SOI layer, the buried oxide layer, and the defect aggregate layer. Furthermore, the nickel concentration in the bulk layer was 6×10¹¹ to 4.8×10¹¹ atoms/cm³, and it was revealed that heavy metal impurities are assuredly gettered by oxide precipitates formed in the bulk layer.

### <Comparative Test 2>

Each of the SIMOX substrates according to Examples 1 to 5 and Comparative Examples 1 and 2 was cleaved into two. Both the cleaved substrates were preferentially etched with a Write etchant. First, oxide precipitates present at a depth of 2 µm from a substrate cleaved front surface were measured to obtain its density by observing one substrate with an optical microscope. An oxide precipitate density in each of the SIMOX substrates according to Comparative Examples 1 and 2 was 5x10⁷ pieces/cm² or below. On the other hand, an oxide precipitate density in each of the SIMOX substrates according to Examples 1 to 5 was in the range of 1×10⁸ to 1x10¹² pieces/cm³. Moreover, a DZ layer (Denuded Zone) including no oxide precipitate was present in a region having a depth of 10 µm from a position immediately below the buried oxide layer.
Then, the other substrate was observed with an electron microscope to obtain a size of each oxide precipitate. It was revealed that sizes of the oxide precipitates were 50 mm or below in the SIMOX substrates according to Comparative Examples 1 and 2 whereas sizes of almost all of the oxide precipitates were 50 nm or above in the SIMOX substrates according to Examples 1 to 5.

### <Comparative Test 3>

When a part of a sample obtained in Example 5 was measured by using an FT-IR (Fourier transform infrared absorption spectroscopy) device to measure a concentration of remaining oxygen after the heat treatments, the concentration of remaining oxygen was 5x10¹⁷ atoms/cm³, but there was no change in an amount of warpage before and after the oxide precipitate growth heat treatment.

### <Example 6>

First, as shown in FIG. 2(a), a CZ silicon wafer sliced with a predetermined thickness from a silicon ingot which was grown by a CZ method and has an oxygen concentration of 1.0×10¹⁸ atoms/cm³ (old ASTM) and a specific resistance of 20 Ω·cm was prepared. Then, this wafer was heated to a temperature of 550°C, and oxygen ions were implanted into a predetermined region (e.g., a region which is approximately 0.4 µm from a substrate front surface) of the silicon wafer in this state under the following conditions.

Accelerating voltage: 180 keV
Beam current: 50 mA
Dose amount: 4×10¹⁷/cm²
After ion implantation, SC-1 and SC-2 cleaning was carried out with respect to wafer surfaces. Subsequently, as shown in FIG. 2(b), there was carried out a first heat treatment of putting the wafer 11 into a vertical heat treatment furnace, maintaining the wafer 11 in an Ar gas atmosphere having an oxygen partial pressure of 0.5% at a fixed temperature of 1350°C for 4 hours, then increasing the oxygen partial pressure of the in-furnace atmosphere to 70%, and further maintaining the wafer 11 for 4 hours. As shown in FIG. 2(c), there was performed a rapid heat treatment of increasing a temperature of this wafer subjected to the first heat treatment in a gas atmosphere containing ammonia to 1150°C at a temperature-up speed of 50°C/minute and then reducing the temperature to 400°C at a temperature-down speed of 50°C/minute. There was carried out a second heat treatment of putting the wafer 11 subjected to this rapid heat treatment into a lateral batch type furnace and maintaining it in an argon atmosphere at a fixed temperature of 800°C for 48 hours in a state where oxide films 11b and 11c on the surfaces are left. The oxide films 11b and 11c on the front surface and the rear surface of the wafer subjected to the heat treatments were removed by using an HF solution, thereby obtaining a SIMOX substrate. This SIMOX substrate was determined as Example 6.

### <Comparative Test 4>

Each of the SIMOX substrates according to Examples 1 and 6 was cleaved into two. The cleaved substrates were preferentially etched with a Write etchant. Oxide precipitates present at a depth of 3 µm from the substrate cleaved front surface were measured to obtain its density by observing each substrate with an optical microscope. An oxide precipitate density in the SIMOX substrate according to Example 1 was 1×10⁴ pieces/cm² or below. On the other hand, an oxide precipitate density in the SIMOX substrate according to Example 6 was in the range of 8×10⁴ pieces/cm³.

### <Comparative Test 5>

After removing the surface oxide films 11b and 11c of each SIMOX substrate 10 according to each of Example 6 and Comparative Example 1, an SOI layer 13, a buried oxide layer 12, and a defect aggregate layer 14a immediately below the buried oxide layer in each SIMOX substrate were respectively dissolved and collected by using a fluorinated acid/nitric acid aqueous solution, and these collected dissolved liquids were subjected to ICP-MS measurement to measure a nickel concentration in the dissolved liquids. Furthermore, a bulk layer 14 according to each of Example 6 and Comparative Example 1 was divided into a bulk layer excluding a position that is 1 µm from the rear surface and a region that is 1 µm from the rear surface, they are completely dissolved, and nickel concentrations in the respective dissolved liquids were measured.
In the SIMOX substrate according to Example 6, although nickel was detected from the bulk region excluding the position that is 1 µm from the rear surface, nickel was not detected from other regions. On the other hand, in the SIMOX substrate according to Comparative Example 1, nickel was detected from the defect aggregate layer 14a immediately below the buried oxide layer.

### INDUSTRIAL APPLICABILITY

In the SIMOX substrate according to the present invention, the gettering source consisting of the oxide precipitates is provided in the bulk layer below the defect aggregate layer, the density of the oxide precipitates is 1×10⁸ to 1×10¹² pieces/cm³, the sizes of the oxide precipitates are 50 nm or above, and hence the gettering source becomes stronger than the defect aggregate layer, thereby reducing the concentration of a trapped heavy metal in the defect aggregate layer and efficiently trapping the heavy metal in the bulk layer.

## Claims

1. A method of manufacturing a SIMOX substrate, comprising:
a step of implanting oxygen ions into a silicon wafer (11); and
a step of performing a first heat treatment to the wafer (11) in a mixed gas atmosphere of oxygen and an inert gas at 1300 to 1390°C to form a buried oxide layer (12) in a region having a predetermined depth from a front surface of the wafer (11) and also form an SOI layer (13) on the wafer front surface above the buried oxide layer (12),
wherein the silicon wafer (11) before the oxygen ion implantation has an oxygen concentration of 8x10¹⁷ to 1.8 X10¹⁸ atoms/cm³ (old ASTM) and the buried oxide layer (12) is formed over the entire wafer surface, and
wherein the method includes:
a step of performing a second heat treatment to the wafer subjected to the first heat treatment in oxygen, nitrogen, argon, hydrogen, or a mixed gas atmosphere containing these components at 400 to 900°C for 1 to 96 hours to form oxide precipitate nuclei (14b) in a bulk layer (14) below a defect aggregate layer (14a) formed immediately below the buried oxide layer (12); and
a step of performing a third heat treatment to the wafer subjected to the second heat treatment in oxygen, nitrogen, argon, hydrogen, or a mixed gas atmosphere containing these components at 900 to 1250°C higher than the second heat treatment temperature for 1 to 96 hours to grow the oxide precipitate nuclei (14b) formed in the bulk layer (14) into oxide precipitates (14c).

2. The manufacturing method according to claim 1,
wherein the second heat treatment is carried out in the range of 1 to 96 hours by increasing a temperature in a part or all of the range of 400°C to 900°C at a speed of 0.1 to 5.0°C/minute, and the third heat treatment is performed in the range of 1 to 96 hours by increasing a temperature in a part or all of the range of 900°C to 1250°C at a speed of 0.1 to 20°C/minute.

3. A method of manufacturing a SIMOX substrate, comprising:
a step of implanting oxygen ions into a silicon wafer (11); and
a step of performing a first heat treatment to the wafer (11) in a mixed gas atmosphere of oxygen and an inert gas at 1300 to 1390°C to form a buried oxide layer (12) in a region having a predetermined depth from a front surface of the wafer (11) and also form an SOI layer (13) on the wafer front surface above the buried oxide layer (12),
wherein the silicon wafer (11) before the oxygen ion implantation has an oxygen concentration of 8x10¹⁷ to 1.8×10¹⁸ atoms/cm³ (old ASTM) and the buried oxide layer (12) is formed on a part or all of the entire wafer surface, and
wherein the method includes:
a step of performing a rapid heat treatment of maintaining the wafer subjected to the first heat treatment at 1050 to 1350°C for 1 to 900 seconds and then reducing the temperature at a temperature-down speed of 10°C/second or above to implant vacancies into a bulk layer (14) below the buried oxide layer (12), and
a step of performing a second heat treatment to the wafer subjected to the rapid heat treatment in oxygen, nitrogen, argon, hydrogen, or a mixed gas atmosphere containing these components at 500 to 1000°C for 1 to 96 hours to form oxide precipitate nuclei (14b) in the bulk layer (14) below a defect aggregate layer (14a) formed immediately below the buried oxide layer (12).

4. The manufacturing method according to claim 3, further comprising a step of performing a third heat treatment to the wafer subjected to the second heat treatment in oxygen, nitrogen, argon, hydrogen, or a mixed gas atmosphere containing these components at 900 to 1250°C higher than the second heat treatment temperature for 1 to 96 hours to grow the oxide precipitate nuclei (14b) formed in the bulk layer (14) into oxide precipitates (14c).

5. The manufacturing method according to claim 3,
wherein the second heat treatment is carried out in the range of 1 to 96 hours by increasing a temperature in a part or all of the range of 500°C to 1000°C at a speed of 0.1 to 5.0°C/minute.

6. The manufacturing method according to claim 4,
wherein the third heat treatment is carried out in the range of 1 to 96 hours by increasing a temperature in a part or all of the range of 900°C to 1250°C at a speed of 0.1 to 20°C/minute.

7. A SIMOX substrate manufactured by the method according to any one of claims 1 to 6, comprising: a buried oxide layer (12) formed in a region having a predetermined depth from a wafer front surface; an SOI layer (13) formed on the wafer front surface above the buried oxide layer; a defect aggregate layer (14a) formed immediately below the buried oxide layer (12); and a bulk layer (14) below the buried oxide layer (12),
wherein a gettering source consisting of oxide precipitates (14c) is provided in the bulk layer (14) below the defect aggregate layer (14a), a density of the oxide precipitates (14c) is 1×10⁸ to 1×10¹² pieces/cm³, and sizes of the oxide precipitates (14c) are 50 nm or above.
